(19) Europäisches Patentamt
European Patent Office
Office européen des brevets

(11) EP 4 403 594 A1

(12) EUROPEAN PATENT APPLICATION

(43) Date of publication:
**24.07.2024 Bulletin 2024/30**

(21) Application number: **24150149.3**

(22) Date of filing: **03.01.2024**

(51) International Patent Classification (IPC):
***C08G 73/12*** *(2006.01)* ***C08K 5/3445*** *(2006.01)*
***C08L 79/08*** *(2006.01)* ***C09J 4/00*** *(2006.01)*
***H01L 23/29*** *(2006.01)* ***H01L 23/00*** *(2006.01)*
***C08F 290/06*** *(2006.01)* ***C08L 71/12*** *(2006.01)*
***C09D 4/00*** *(2006.01)* ***G03F 7/00*** *(2006.01)*
***G03F 7/027*** *(2006.01)* ***H05K 1/03*** *(2006.01)*
***H05K 3/02*** *(2006.01)*

(52) Cooperative Patent Classification (CPC):
(C-Sets available)
**C08L 79/085; C08F 290/062; C08G 73/12; C08G 73/124; C08G 73/127; C08K 5/3445; C08L 79/08; C09D 4/00; C09J 4/00; G03F 7/00; G03F 7/027; H01L 23/293; H01L 24/29; H05K 1/0346; H05K 3/022** (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.01.2023 JP 2023005989**

(71) Applicant: **Shin-Etsu Chemical Co., Ltd.**
**Tokyo 100-0005 (JP)**

(72) Inventors:
- **TSUTSUMI, Yoshihiro**
  **Gunma, 379-0224 (JP)**
- **IWASAKI, Masayuki**
  **Gunma, 379-0224 (JP)**

(74) Representative: **Angerhausen, Christoph**
**Boehmert & Boehmert**
**Anwaltspartnerschaft mbB**
**Pettenkoferstrasse 22**
**80336 München (DE)**

# (54) CURABLE MALEIMIDE RESIN COMPOSITION, ADHESIVE, PRIMER, CHIP COATING AGENT, AND SEMICONDUCTOR DEVICE

(57) Provided are a curable maleimide resin composition and others, in which the curable maleimide resin composition is one that does not employ an aprotic polar solvent such as NMP, can be cured at a temperature lower than 250°C which is a temperature at which a normal polyimide cures, and can particularly be turned into a cured product having a superior adhesiveness to copper. The curable maleimide resin composition contains:
(A) a maleimide compound that has a bisphenol structure and a number average molecular weight of 5,000 to 50,000;
(B) a reaction initiator; and
(C) a diaminotriazine ring-containing imidazole.

EP 4 403 594 A1

(52) Cooperative Patent Classification (CPC): (Cont.)

C-Sets
**C08L 79/08, C08K 5/3445**

## Description

TECHNICAL FIELD

The present invention relates to a curable maleimide resin composition, an adhesive, a primer, a chip coating agent, and a semiconductor device.

BACKGROUND ART

Power semiconductor modules are widely applied in fields where efficient power conversion is required. For example, the field of application thereof has expanded to fields of power electronics, such as industrial equipments, electric vehicles, and home appliances. These power semiconductor modules have built-in switching elements and diodes, and Si (silicone) semiconductors or SiC (silicone carbide) semiconductors are used in the elements.

Conventionally, resin compositions using curable epoxy resins or cyanate resins have been widely used to protect semiconductor elements (Patent documents 1 and 2). However, there has been a problem where when operating a semiconductor device at a high temperature, since semiconductor elements, a base material, and an encapsulation material differ from one another in linear expansion coefficient, stress will be applied to the periphery of the semiconductor device when the device is subjected to a heat cycle or the like, and peeling of the encapsulation material is thus likely to occur.

Further, there has also been a problem where since a curable resin component(s) used in an encapsulation material has a low moisture-proof property, and since a cured product obtained has a high hardness, adhesion may not take place in the step of encapsulating the semiconductor elements, and peeling is often observed even in subsequent steps, which has incurred reliability degradation as a package.

In order to solve these problems, there are known methods of providing a primer layer on semiconductor elements and lead frames (Patent documents 3 and 4). Polyimide resin is mainly used for this primer layer. Since polyimide resins excel in, for example, heat resistance, flame retardance, mechanical properties, and electrical insulation property, they are widely used as varnishes for interlayer insulation films or surface protective films of semiconductors. For example, there are disclosures showing how a polyimide resin in the form of a varnish may be applied to a semiconductor element or the like either directly or via an insulation film, whereafter the resin is cured to form a protective film comprised of polyimide resin, and encapsulation may be further carried out with a molding material such an epoxy resin (Patent documents 5 and 6).

This polyimide varnish is generally produced by dissolving a polyimide in N-methyl-2-pyrrolidone (NMP). NMP has long been used as an aprotic polar solvent in many places; however, due to its high boiling point and toxicity, regulations imposed thereon are becoming rigorous, especially and mostly in Europe. Further, an alternative material for polyimide is desired due to, for example, a problem that an extremely high temperature of 250°C or higher is required to cure a polyimide, and a problem that a polyimide itself is susceptible to moisture absorption.

In order to solve these problems, there has been made a proposal to use a heat-curable cyclic imide resin composition that is curable at a relatively low temperature as a primer (Patent document 7). In recent years, unplated copper is often used as a material for lead frames; in the invention disclosed in Patent document 7, in order to ensure an adhesion force to copper, it is proposed that curing be performed under a nitrogen atmosphere, and that an organic peroxide with a low half-life temperature be used as a reaction initiator. However, it has now become clear that a further improvement in adhesion force is necessary in order for a material to be used as a primer for semiconductor elements and lead frames.

In the meantime, reports have been made on a resin composition containing a maleimide compound and a specific triazine frame-containing compound (Patent document 8). This resin composition is primarily intended for substrate use, and is said to have an excellent adhesion force to metals; however, it has now become clear that the composition has a problem in long-term reliability.

PRIOR ART DOCUMENTS

[Patent documents]

[Patent document 1] JP-A-2015-48434
[Patent document 2] JP-A-2015-93971
[Patent document 3] JP-A-2019-176085
[Patent document 4] JP-A-2022-148684

[Patent document 5] JP-A-2007-8977
[Patent document 6] JP-A-2010-70645
[Patent document 7] JP-A-2021-25031
[Patent document 8] WO2020/111065

SUMMARY OF THE INVENTION

[Problems to be solved by the invention]

Thus, it is an object of the present invention to provide a curable maleimide resin composition that does not employ an aprotic polar solvent such as NMP, can be cured with lights and/or at a temperature lower than 250°C which is a temperature at which a normal polyimide cures, and can particularly be turned into a cured product having a superior adhesiveness to copper; an adhesive, substrate material, primer, and chip coating agent each using such composition; and a semiconductor device having a cured product of such composition.

[Means to solve the problems]

In order to solve the above problems, the inventors of the present invention diligently conducted a series of studies, and completed the invention by finding that the curable maleimide resin composition shown below is able to achieve the aforementioned object.

Specifically, the present invention is to provide the following curable maleimide resin composition and others.

[1] A curable maleimide resin composition comprising:

(A) a maleimide compound that is represented by a formula (1) or (2), and has a number average molecular weight of 5,000 to 50,000;
(B) a reaction initiator; and
(C) a diaminotriazine ring-containing imidazole,

the formula (1) being

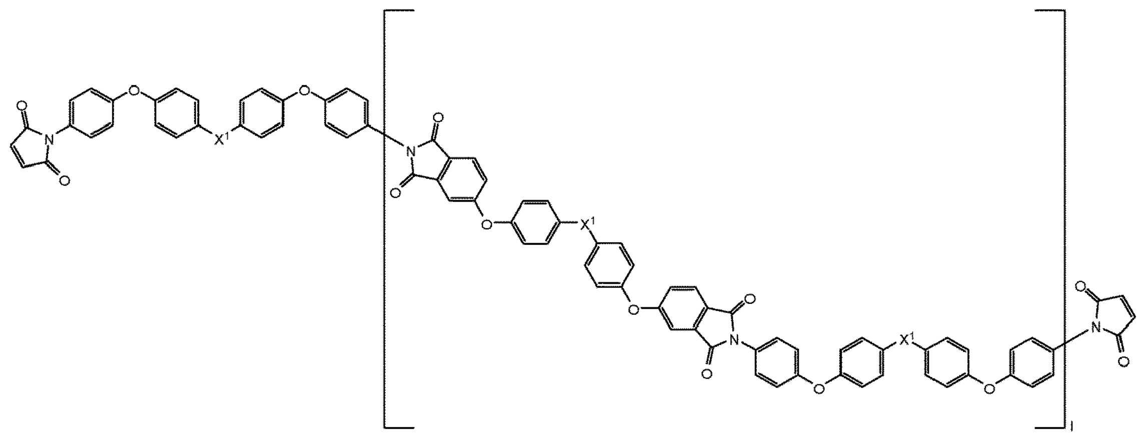

(1)

wherein in the formula (1), $X^1$ independently represents a divalent group selected from groups expressed by the following formulae, l is a number of 1 to 40

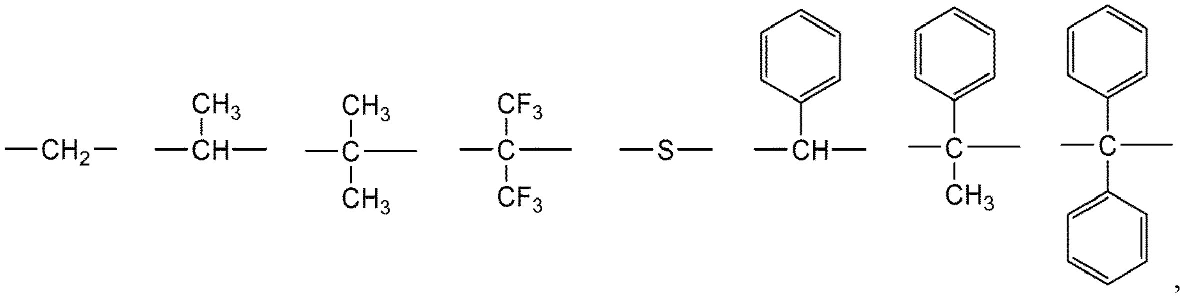,

the formula (2) being

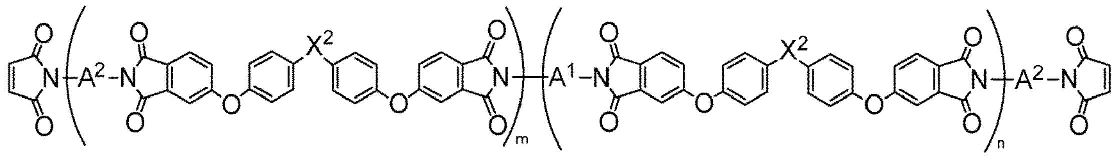

(2)

wherein in the formula (2), $X^2$ independently represents a divalent group selected from groups expressed by the following formulae, m is a number of 1 to 50, n is a number of 1 to 50, each of $A^1$ and $A^2$ independently represents a group expressed by a formula (3) or (4)

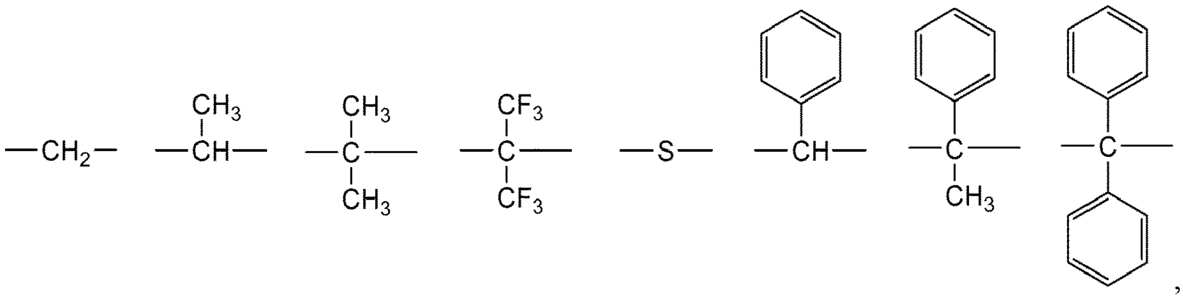,

the formulae (3) and (4) being

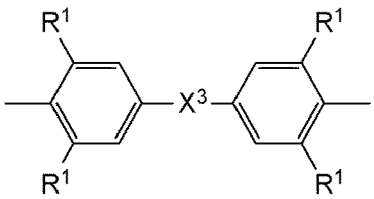

(3)

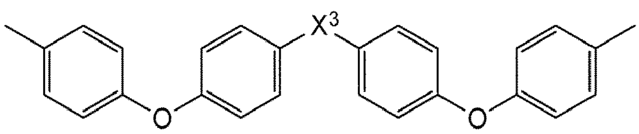

(4)

wherein in the formulae (3) and (4), $X^3$ represents a divalent group selected from groups expressed by the following formulae, $R^1$ in the formula (3) independently represents a hydrogen atom, a chlorine atom, or a substituted or unsubstituted aliphatic hydrocarbon group having 1 to 6 carbon atoms

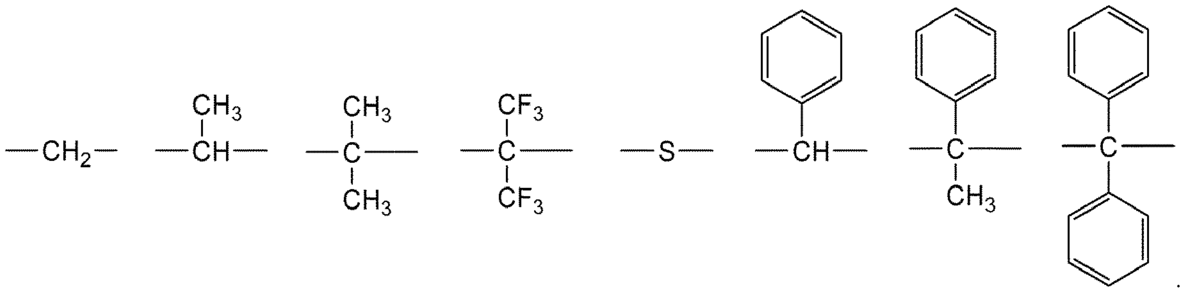

[2] The curable maleimide resin composition according to [1], wherein the component (B) is contained in an amount of 0.05 to 10 parts by mass per 100 parts by mass of the component (A), and the component (C) is contained in an amount of 0.05 to 5 parts by mass per 100 parts by mass of the component (A).
[3] The curable maleimide resin composition according to [1], further comprising (D) an organic solvent.
[4] An adhesive comprised of the curable maleimide resin composition according to any one of [1] to [3].
[5] A primer comprised of the curable maleimide resin composition according to any one of [1] to [3].
[6] A chip coating agent comprised of the curable maleimide resin composition according to any one of [1] to [3].
[7] A semiconductor device having a cured product of the curable maleimide resin composition according to any one of [1] to [3].

[Effects of the invention]

The curable maleimide resin composition of the present invention does not employ an aprotic polar solvent such as NMP, can be cured at a low temperature (e.g., a temperature lower than 250°C), and can particularly be turned into a cured product having a superior adhesiveness to copper. In this way, the curable maleimide resin composition of the present invention is useful in that there can be obtained an adhesive, a primer, and a chip coating agent each using such composition; and a semiconductor device having the cured product of such composition.

MODE FOR CARRYING OUT THE INVENTION

The present invention is described in greater detail hereunder.

(A) Specific maleimide compound

A component (A) is a maleimide compound that is represented by the following formula (1) or (2), and has a number average molecular weight of 5,000 to 50,000.

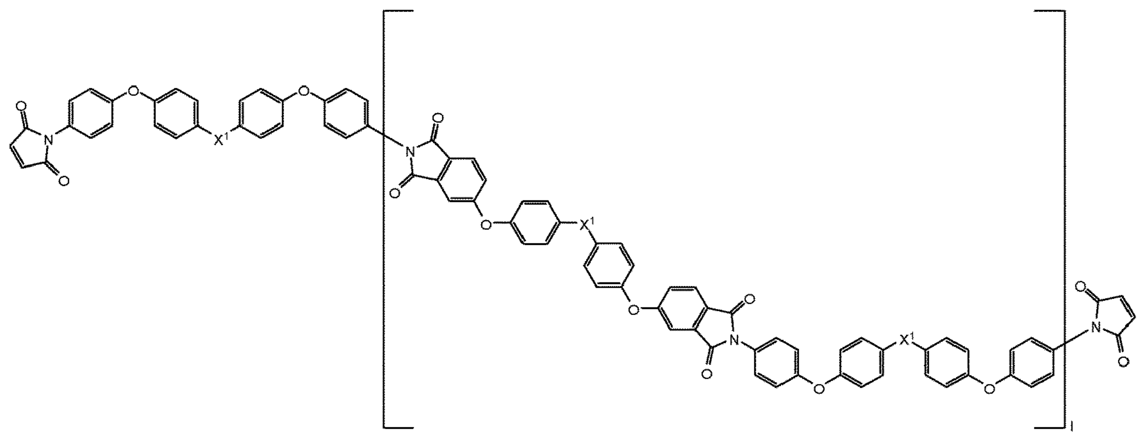

(1)

In the formula (1), $X^1$ independently represents a divalent group selected from groups expressed by the following formulae.

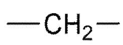 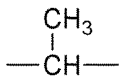 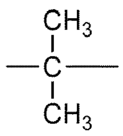 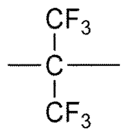 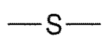 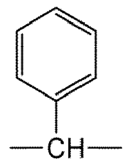 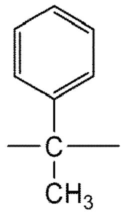 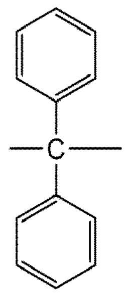

In terms of raw material availability, it is preferred that $X^1$ in the formula (1) be $-CH_2-$ and $-C(CH_3)_2-$.

In the formula (1), l is a number of 1 to 40, preferably a number of 5 to 30.

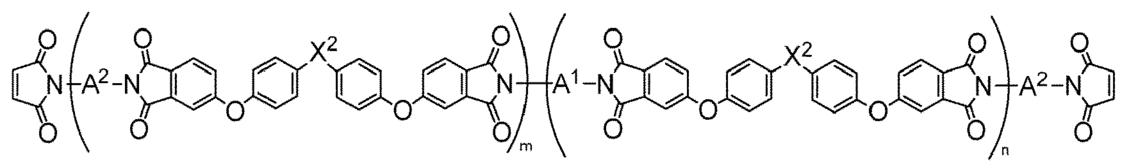

(2)

In the formula (2), $X^2$ independently represents a divalent group selected from groups expressed by the following formulae.

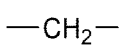 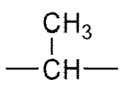 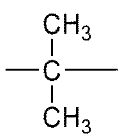 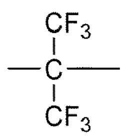 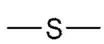 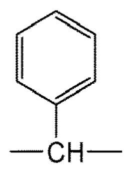 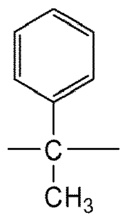 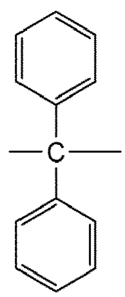

In terms of raw material availability, it is preferred that $X^2$ in the formula (2) be $-CH_2-$ and $-C(CH_3)_2-$.

In the formula (2), m is a number of 1 to 50, preferably a number of 1 to 40.

In the formula (2), n is a number of 1 to 50, preferably a number of 1 to 40.

In the formula (2), each of $A^1$ and $A^2$ independently represents a group expressed by the following formula (3) or (4).

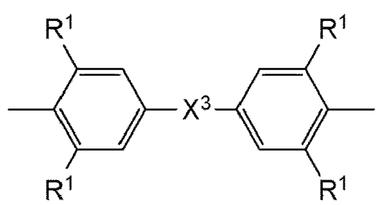

(3)

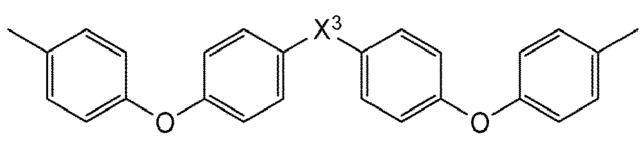

(4)

In the formulae (3) and (4), $X^3$ represents a divalent group selected from groups expressed by the following formulae.

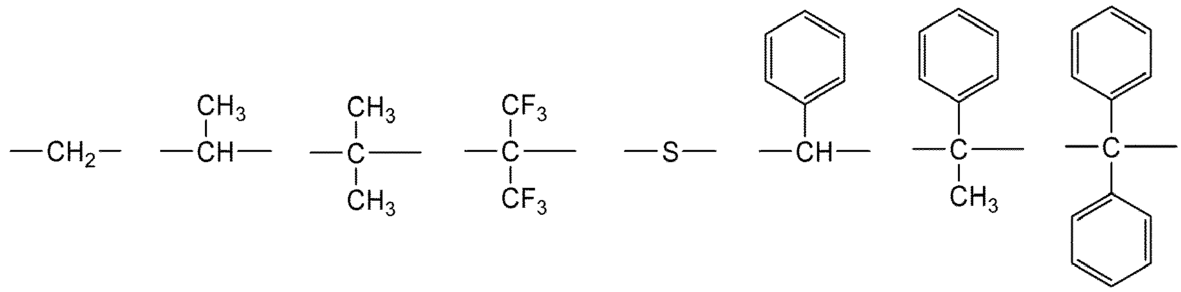

In terms of raw material availability, it is preferred that $X^3$ in the formulae (3) and (4) be $-CH_2-$ and $-C(CH_3)_2-$.

In the formula (3), $R^1$ independently represents a hydrogen atom, a chlorine atom, or a substituted or unsubstituted aliphatic hydrocarbon group having 1 to 6 carbon atoms.

As the substituted or unsubstituted aliphatic hydrocarbon group having 1 to 6 carbon atoms, which is represented by $R^1$ in the formula (3), there may be listed, for example, a methyl group; an ethyl group; a n-propyl group; an isopropyl group; a n-butyl group; a t-butyl group; a cyclohexyl group; and groups obtained by substituting part of or all the hydrogen atoms in any of these groups with, for example, halogen atoms such as F, Cl and Br atoms, where such substituted groups may be exemplified by a trifluoromethyl group. In terms of raw material availability, it is preferred that $R^1$ be a hydrogen atom or a substituted or unsubstituted aliphatic hydrocarbon group having 1 to 3 carbon atoms.

Further, in the maleimide compound represented by the formula (2), it is preferred that $A^1$ and $A^2$ mutually represent different groups. For example, in the formula (2), when $A^1$ is the group represented by the formula (3), $A^2$ is the group represented by the formula (4); and, for example, when $A^1$ is the group represented by the formula (4), $A^2$ is the group represented by the formula (3).

Moreover, a bonding pattern of the repeating units with the repetition numbers m and n in the maleimide compound of the formula (2) may be random or block; in terms of mechanical strength of a cured product, a block bonding pattern is preferred.

As indicated in the formula (1) or (2), the component (A) has a bisphenol structure in its molecule so that the component (A) can be produced without using NMP and has an excellent solvent solubility where the component (A) is even soluble in a solvent other than NMP. Further, a bisphenol structure-containing maleimide compound is preferable even from the perspective of raw material availability or the like. Examples of the bisphenol structure in the component (A) include, but are not limited to those of bisphenol A, bisphenol F, bisphenol E, and bisphenol AF, of which bisphenol A is preferred. Further, in the case of the maleimide compound represented by the formula (1) or (2), since l, m and n are each in the above ranges, a composition containing such maleimide compound has a favorable solubility in a solvent and a favorable film-forming capability when in an uncured state, and a cured product of such composition will exhibit a favorable balance between rigidity and heat resistance.

The number average molecular weight of the maleimide compound as the component (A) is 5,000 to 50,000, preferably 7,000 to 40,000, more preferably 10,000 to 20,000. When the number average molecular weight is within these ranges, the maleimide compound as the component (A) can be stably dissolved in a solvent, particularly, there will also be observed a favorable film-forming capability before curing.

Here, the number average molecular weight mentioned in this specification refers to a number average molecular weight that is measured by gel permeation chromatography (GPC) under the following measurement conditions, using polystyrene as a reference substance.

[GPC measurement conditions]

Developing solvent: Tetrahydrofuran
Flow rate: 0.35 mL/min
Detector: Differential refractive index detector (RI)
Column: TSK-GEL H type (by Tosoh Corporation)
Column temperature: 40°C
Sample injection volume: 5 μL (THF solution with a concentration of 0.2% by mass)

It is preferred that the maleimide compound as the component (A) satisfy the following formula (5).

$$\text{Number of aromatic atoms/Number of all atoms other than hydrogen atoms} > 0.5 \qquad (5)$$

The fact that a compound satisfies the formula (5) indicates that there are many aromatic rings in the compound. The maleimide compound as the component (A) is preferably a compound satisfying Number of aromatic atoms/Number of all atoms other than hydrogen atoms>0.55.

The number of aromatic atoms refers to the number of atoms composing the aromatic moiety structure(s) in the component (A). Here, examples of an aromatic moiety structure include a benzene ring, a pyridine ring, a pyrrole ring, a furan ring, a thiophene ring, an imidazole ring, and oxazole ring. Excluded from the number of aromatic atoms are the number of hydrogen atoms bonded to the atoms composing the aromatic moiety structures; the number of halogen atoms if the hydrogen atoms bonded to the atoms composing the aromatic moiety structures are substituted by halogen atoms; and the number of the atoms in substituent groups such as an alkyl group and an alkoxy group. Further, the number of all atoms other than hydrogen atoms refers to the number of atoms other than the hydrogen atoms in the component (A), which may include, for example, nitrogen atoms, oxygen atoms, sulfur atoms, and halogen atoms in addition to carbon atoms. That is, the closer the value of "number of aromatic atoms/number of all atoms other than hydrogen atoms" is to 1, the higher the ratio of aromatics is.

Since the component (A) satisfies the formula (5) and has many aromatic rings, especially benzene rings in its molecule, there can be improved many mechanical properties such as low moisture absorbency, film strength, and voltage resistance.

The maleimide compound as the component (A) which is represented by the formula (1) or (2) can, for example, be produced by a method disclosed in JP-A-2021-017485.

As for the maleimide compound as the component (A), one kind thereof may be used alone, or two or more kinds thereof may be used in combination.

Further, the component (A) is preferably contained in the curable maleimide resin composition of the present invention (or in the curable maleimide resin composition of the present invention excluding a later-described organic solvent (D), if the composition contains such organic solvent (D)) by an amount of 70 to 99.9% by mass, more preferably 80 to 99.5% by mass, even more preferably 85 to 99.0% by mass.

(B) Reaction initiator

A reaction initiator as a component (B) is added to initiate and promote a cross-linking reaction of the maleimide compound as the component (A), and a reaction between the maleimide groups in the component (A) and reactive groups capable of reacting with them.

There are no particular restrictions on the component (B) so long as it is capable of promoting a cross-linking reaction; in terms of improving productivity, preferred are a thermal radical polymerization initiator and/or a photopolymerization initiator as the composition is likely cured in a short period of time if using these reaction initiators. If using a thermal radical polymerization initiator as the component (B), the curable maleimide resin composition of the present invention cures at a relatively low temperature (e.g., a temperature lower than 250°C); if using a photopolymerization initiator as the component (B), the composition of the invention cures when irradiated with lights. Here, the component (B) does not include a later-described diaminotriazine ring-containing imidazole.

Typical examples of a thermal radical polymerization initiator include organic peroxides, specific examples of which may include dicumyl peroxide, t-butyl peroxybenzoate, t-amyl peroxybenzoate, dibenzoyl peroxide, , 2,5-dimethyl-2,5-di(t-butylperoxy)hexane, 1,1-di(t-butylperoxy)cyclohexane, di-t-butylperoxide, dibenzoyl peroxide, and 1,6-bis(t-butylperoxycarbonyloxy)hexane.

There are no particular restrictions on a photopolymerization initiator so long as it is capable of initiating a reaction with lights. Examples of a photopolymerization initiator may include aromatic ketones such as 2-benzyl-2-dimethylamino-1-(4-morpholinophenyl)-butanone-1, 2,2-dimethoxy-1,2-diphenylethan-1-one, 1-hydroxy-cyclohexyl-phenyl-ketone, 2-methyl-1-(4-(methylthio)phenyl)-2-morpholinopropanone-1,2,4-diethylthioxanthone, 2-ethylanthraquinone, and phenanthrenequinone; a benzyl derivative such as benzyl dimethyl ketal; 2,4,5-triarylimidazole dimers such as 2-(o-chlorophenyl)-4,5-diphenylimidazole dimer, 2-(o-chlorophenyl)-4,5-di(m-methoxyphenyl)imidazole dimer, 2-(o-fluorophenyl)-4,5-phenylimidazole dimer, 2-(o-methoxyphenyl)-4,5-diphenylimidazole dimer, 2-(p-methoxyphenyl)-4,5-diphenylimidazole dimer, 2,4-di(p-methoxyphenyl)-5-phenylimidazole dimer, and 2-(2,4-dimethoxyphenyl)-4,5-diphenylimidazole dimer; acridine derivatives such as 9-phenylacridine and 1,7-bis(9,9'-acridinyl)heptane; bisacylphosphine oxides such as bis(2,6-dimethoxybenzoyl)-2,4,4-trimethyl-pentylphosphine oxide and bis(2,4,6-trimethylbenzoyl)-phenylphosphine oxide; alkylphenone-based compounds such as 1-hydroxy-cyclohexyl-phenyl-ketone, 2-benzyl-2-dimethylamino-1-(4-morpholinophenyl)-butanone-1, and 2-(dimethylamino)-2-[(4-methylphenyl)methyl]-1-[4-(4-morpholinyl)phenyl]-1-butanone; an acylphosphine oxide-based compound such as 2,4,6-trimethylbenzoyl-diphenyl-phosphine oxide; and a benzophenone compound.

The reaction initiator is preferably contained in an amount of 0.05 to 10 parts by mass, more preferably 0.1 to 5 parts by mass, per 100 parts by mass of the component (A). Further, if a later-described other heat-curable resin is to be added to the composition, it is preferred that the reaction initiator be contained in an amount of 0.05 to 10 parts by mass, particularly preferably 0.1 to 5 parts by mass, per 100 parts by mass of a sum total of the component (A) and such other heat-curable resin component. It is not preferable if the amount of the reaction initiator is out of the range of 0.05 to 10 parts by mass per 100 parts by mass of the component (A), because curing may take place either extremely slowly or quickly at the time of molding. Moreover, the cured product obtained may exhibit a poor balance between heat resistance and moisture resistance.

Here, as for the reaction initiator, one kind thereof may be used alone, or two or more kinds thereof may be used in combination.

(C) Diaminotriazine ring-containing imidazole

In the present invention, there may further be added a diaminotriazine ring-containing imidazole as a component (C). Particularly, diaminotriazine rings are effective in improving an adhesion force to a metal as typified by copper. Further, the presence of imidazole is effective in promoting polymerization of maleimide and imparting heat resistance. There are no particular restrictions on the component (C) so long as it is a diaminotriazine ring-containing imidazole.

Specific examples thereof include 2,4-diamino-6-[2'-methylimidazolyl-(1')]-ethyl-s-triazine (2MZ-A by SHIKOKU KASEI HOLDINGS CORPORATION), 2,4-diamino-6-[2'-undecylimidazolyl-(1')]-ethyl-s-triazine (C11Z-A by SHIKOKU KASEI HOLDINGS CORPORATION), 2,4-diamino-6-[2'-ethyl-4'-methylimidazolyl-(1')]-ethyl-s-triazine (2E4MZ-A by SHIKOKU KASEI HOLDINGS CORPORATION), and 2,4-diamino-6-[2'-methylimidazolyl-(1') )]-ethyl-s-triazine isocyanuric acid adduct (2MA-OK by SHIKOKU KASEI HOLDINGS CORPORATION).

The component (C) is preferably contained in an amount of 0.05 to 5 parts by mass, more preferably 0.1 to 2 parts by mass, per 100 parts by mass of the component (A). When the component (C) is contained in an amount of smaller than 0.05 parts by mass per 100 parts by mass of the component (A), there cannot be achieved the effect of improving adhesion force; when the component (C) is contained in an amount of greater than 5 parts by mass per 100 parts by mass of the component (A), there will be observed a poor dispersibility, which may lead to a poor appearance and a deteriorated reliability.

(D) Organic solvent

The composition of the present invention may further contain an organic solvent as a component (D). There are no restrictions on the type of such organic solvent as the component (D) so long as the component (D) is capable of dissolving the component (A); in view of environmental burden, N-methyl-2-pyrrolidone (NMP) shall be excluded from its candidate.

Here, the expression "the component (D) is capable of dissolving the component (A)" refers to a condition where after 25% by mass of the component (A) was added to the component (D), there cannot be visually confirmed undissolved residues of the component (A) at 25°C.

Examples of the component (D) include general organic solvents such as methyl ethyl ketone (MEK), cyclohexanone, ethyl acetate, tetrahydrofuran (THF), isopropanol (IPA), xylene, toluene, and anisole. Any one of these organic solvents may be used alone, or two or more kinds of them may be used in combination.

If the composition of the present invention is used as a primer for a copper substrate, the organic solvent as the component (D) is preferably cyclohexanone, xylene, anisole and the like.

In terms of solubility of the component (A), the organic solvent as the component (D) is preferably an organic solvent such as anisole, xylene, toluene, and cyclohexanone. Meanwhile, due to a high boiling point and toxicity, it is preferred that an aprotic polar solvent as typified by NMP, such as dimethylsulfoxide (DMSO) and dimethylformamide (DMF), is not used. Unlike a conventional composition containing a polyimide compound that can only be dissolved in an aprotic polar solvent, the composition of the present invention has an advantage of not having to use these aprotic polar solvents.

The component (D) is preferably contained in an amount of 100 to 800 parts by mass, more preferably 150 to 700 parts by mass, per 100 parts by mass of the component (A).

<Other additives>

Various additives may be added to the curable maleimide resin composition of the present invention to the extent that the effects of the present invention are not impaired. For example, in order to improve resin properties, there may be added, for example, a curable resin such as an acrylic resin, an organopolysiloxane, a silicone oil, a thermoplastic resin, a thermoplastic elastomer, an organic synthetic rubber, a light stabilizer, a polymerization inhibitor, a flame retardant,

a pigment, a dye, and an adhesion aid. Further, in order to improve electric properties, there may also be added an ion-trapping agent or the like. Furthermore, in order to improve dielectric properties, there may also be added a fluorine-containing material or the like. In order to adjust coefficient of thermal expansion (CTE), an inorganic filler such as silica may also be added.

The curable maleimide resin composition of the present invention can be produced by mixing the components (A), (B), (C) and (D) as well as other additives.

The curable maleimide resin composition of the present invention can be used as an adhesive, a primer, a chip coating agent, and a coating material for a semiconductor device. No particular restrictions are imposed on how it is used and its use style.

Usage examples are shown below; however, they shall not be limited to the examples described hereunder.

For example, after applying the curable maleimide resin composition containing the components (A), (B), (C) and (D) to a base material, by performing heating at a temperature of normally not lower than 80°C, preferably not lower than 100°C, for 0.5 to 5 hours, the organic solvent will be removed. Further, a strong maleimide film with a flat surface can be formed by heating the base material at a temperature of not lower than 130°C, preferably not lower than 150°C, for 0.5 to 10 hours if the composition is a heat-curable type; or by irradiating the base material with an UV light of 365 nm if the composition is a photo-curable type. In general, while a polyimide-containing composition requires 150°C or higher for drying and 220°C or higher for heat curing, the curable maleimide resin composition of the present invention does not require such a kind of high temperature condition(s). Specifically, the removal of the organic solvent can be carried out at a temperature of not higher than 150°C, and heat curing (film formation) can take place at a temperature of not higher than 200°C.

In order to efficiently remove the organic solvent in the composition and effectively promote the reaction of the resin, the curing temperature may be raised in a stepwise manner in certain cases, or heating may be performed after the composition was photo-cured. The cured product (film) obtained by curing the composition of the present invention is superior in mechanical properties, heat resistance, relative permittivity, dielectric tangent, moisture resistance, and adhesiveness. Thus, the cured product of the present invention can, for example, be utilized as an adhesive for a semiconductor element and a lead frame; a primer used between a semiconductor encapsulation material and a lead frame; a chip coating agent (passivation film) for coating the surface of a semiconductor element; a junction protective film for use in junctions of diodes, transistor and the like; an $\alpha$-ray shielding film for VLSI; an interlayer insulation film; and a conformal coating for a printed circuit board.

Examples of a coating method include those employing a spin coater, a slit coater, a sprayer, a dip coater, and a bar coater; there are no particular restrictions on such method.

After forming the cured product (film), by molding an epoxy resin molding material for semiconductor encapsulation on such cured product (film), an adhesiveness between the epoxy resin molding material for semiconductor encapsulation and the base material can be improved. In a solder reflow process that is performed after the semiconductor device thus obtained has been exposed to a moisture absorbing condition, there is exhibited no cracks in the epoxy resin molding material for semiconductor encapsulation and no peeling of such molding material from the base material, which makes the semiconductor device highly reliable.

In such case, as the epoxy resin molding material for semiconductor encapsulation, there may be employed a known epoxy resin composition for semiconductor encapsulation that contains, for example, an epoxy resin having at least two epoxy groups per molecule; a phenolic resin; a curing agent for an epoxy resin, such as an acid anhydride; and/or an inorganic filler. As such known epoxy resin composition, there may be used a commercially available one.

If using an easily-oxidizable metal such as copper as the base material, it is preferred that a curable maleimide resin composition and an epoxy resin molding material for semiconductor encapsulation are actually cured under a nitrogen atmosphere for the sake of oxidation prevention. The curable maleimide resin composition of the present invention is likewise preferably cured under a nitrogen atmosphere; however, even if it is cured under an oxygen atmosphere, the adhesion force can be improved to a certain level.

## WORKING EXAMPLES

The present invention is described in detail hereunder with reference to working and comparative examples; however, the invention shall not be limited to the following working examples. Here, in the working and comparative examples, "room temperature" means 25°C.

Components used in the working and comparative examples are shown below. Here, a number average molecular weight (Mn) mentioned hereunder refers to a value that is measured by gel permeation chromatography (GPC) under the following measurement conditions, using polystyrene as a reference substance.

[GPC measurement conditions]

Developing solvent: Tetrahydrofuran
Flow rate: 0.35 mL/min
Detector: Differential refractive index detector (RI)
Column: TSK-GEL H type (by Tosoh Corporation)
Column temperature: 40°C
Sample injection volume: 5 μL (THF solution with a concentration of 0.2% by mass)

(A) Maleimide compound

[Synthesis example 1]

Here, 65.06 g (0.125 mol) of 2,2-bis[4-(2,3-dicarboxyphenoxy)phenyl]propane dianhydride, 61.59 g (0.150 mol) of 2,2-bis[4-(4-aminophenoxy)phenyl]propane, and 250 g of anisole were added to a 1L glass four-necked flask equipped with a stirrer, a Dean-Stark tube, a cooling condenser and a thermometer, followed by stirring them at 80°C for three hours to synthesize an amic acid. Next, the temperature was directly raised to 150°C, and stirring was performed for another two hours while distilling away a water produced as a by-product, thereby obtaining a diamine compound with each end being blocked with an amino group.

After cooling the flask containing this diamine compound solution obtained to room temperature, 4.39 g (0.055 mol) of maleic anhydride was added thereto, followed by performing stirring at 80°C for three hours to synthesize a maleamic acid. Next, the temperature was directly raised to 150°C, and stirring was performed for another two hours while distilling away a water produced as a by-product, thereby obtaining a varnish of an aromatic bismaleimide compound represented by the following formula (A-1). The number average molecular weight (Mn) of the aromatic bismaleimide compound was 12,000. Anisole was further added thereto so that the non-volatile content in the varnish would be in an amount of 17% by mass.

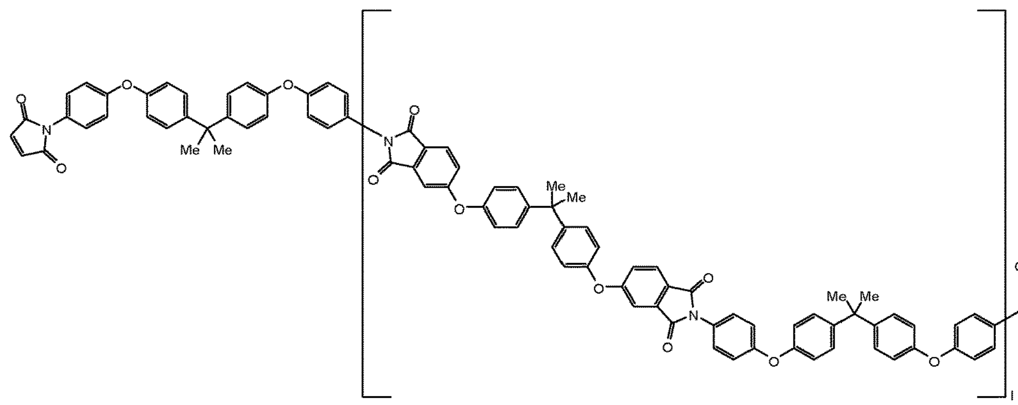

(A − 1)

1≈8 (average value)
(number of aromatic atoms/number of composing atoms≈0.70)

[Synthesis example 2]

Here, 65.06 g (0.125 mol) of 2,2-bis[4-(2,3-dicarboxyphenoxy)phenyl]propane dianhydride, 35.26 g (0.115 mol) of 4,4-methylenebis(2,6-diethylaniline), and 250 g of anisole were added to a 1L glass four-necked flask equipped with a stirrer, a Dean-Stark tube, a cooling condenser and a thermometer, followed by stirring them at 80°C for three hours to synthesize an amic acid. Next, the temperature was directly raised to 150°C, and stirring was performed for another two hours while distilling away a water produced as a by-product, thereby synthesizing a copolymer.

Later, 7.05 g (0.015 mol) of 2,2-bis[4-(4-aminophenoxy)phenyl]propane was added to the copolymer solution-containing flask that had been cooled to room temperature, followed by performing stirring at 80°C for three hours to synthesize an amic acid. Next, the temperature was directly raised to 150°C, and stirring was performed for another two hours while distilling away a water produced as a by-product, thereby synthesizing a diamine compound with each end

being blocked with an amino group.

After cooling the flask containing this diamine compound solution obtained to room temperature, 1.45 g (0.015 mol) of maleic anhydride was added thereto, followed by performing stirring at 80°C for three hours to synthesize a maleamic acid. Next, the temperature was directly raised to 150°C, and stirring was performed for another two hours while distilling away a water produced as a by-product, thereby obtaining a varnish of an aromatic bismaleimide compound represented by the following formula (A-2). The number average molecular weight (Mn) of the aromatic bismaleimide compound was 15,500. Anisole was further added thereto so that the non-volatile content in the varnish would be in an amount of 17% by mass.

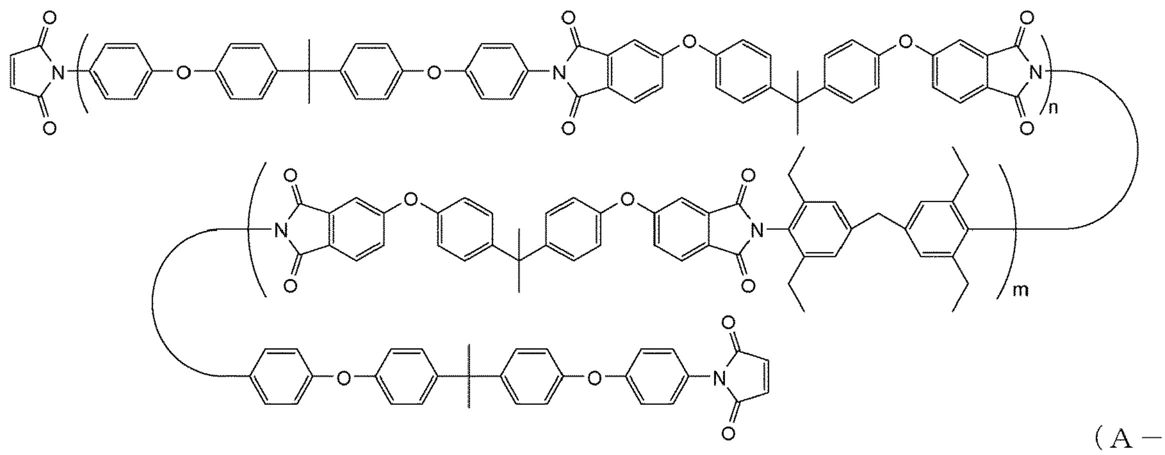

(A − 2)

m≈8, n≈1 (average value)
(number of aromatic atoms/number of composing atoms≈0.60)

Other maleimide compounds

(A-3): Bismaleimide compound represented by the following formula (BMI-5000, Mn: 8,000 by Designer Molecules Inc.)

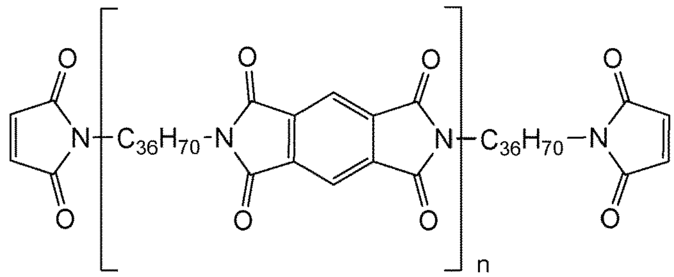

$-C_{36}H_{70}-$ represents a dimer acid frame-derived hydrocarbon group.
n≈8 (average value)
(number of aromatic atoms/number of composing atoms≈0.10)
(A-4): 4,4'-diphenylmethanebismaleimide (BMI-1000, Mn: 410 by Daiwakasei Industry Co., LTD.)
(number of aromatic atoms/number of composing atoms≈0.44)

(B) Reaction initiator

(B-1): Dicumylperoxide (Perkadox BC-FF by KAYAKU NOURYON CORPORATION)
(B-2): 1,6-bis(t-butylperoxycarbonyloxy)hexane (Kayalene 6-70 by KAYAKU NOURYON CORPORATION, one-hour half-life temperature 117°C)

(C) Diaminotriazine ring-containing imidazole

(C-1): 2,4-diamino-6-[2'-ethyl-4'-methylimidazolyl-(1')]-ethyl-s-triazine (2E4MZ-A by SHIKOKU KASEI HOLDINGS CORPORATION)
(C-2): 2-ethyl-4-methylimidazole (2E4MZ by SHIKOKU KASEI HOLDINGS CORPORATION, for use in comparative example)
(C-3): Diaminotriazine frame-containing silane coupling agent (VD-5 by SHIKOKU KASEI HOLDINGS CORPORATION, for use in comparative example)

Polyimide for use in comparative example

A polyamic acid varnish (KJR-655 by Shin-Etsu Chemical Co., Ltd., varnish using NMP, non-volatile content 15% by mass) was directly used.

(Formulation examples 1 to 12, working examples 1 to 6, comparative examples 1 to 14)

The components were mixed at the compounding ratios shown in Table 1 to prepare a varnish of a curable maleimide resin composition. Here, in each formulation, anisole was added so that the component (A) would be in an amount of 16.7% by mass, and the component (A) was completely dissolved.

<Adhesion force> (Adhesion force test before moisture absorption)

The varnish of the composition obtained in each of the formulation examples 1 to 12 was sprayed and thus applied onto a copper frame substrate of 20 mm × 20 mm. The composition was then cured under the curing conditions shown in Table 2 or 3 to form a cured film (primer).

An epoxy resin molding material for semiconductor encapsulation KMC-2284 (by Shin-Etsu Chemical Co., Ltd.) was then molded into the shape of a cylinder having a base area of 10 $mm^2$ and a height of 3 mm on top of the cured film after being cured at a pressure of 6.9 MPa and a temperature of 175°C for 120 sec. Next, post curing was performed at 180°C for four hours to obtain a test piece, and a versatile-type bond tester (DAGE SERIES 4000 by Nordson DAGE) was then used to measure a pre-moisture-absorption adhesion force of such test piece at 25°C at a rate of 0.2 mm/sec.

<Adhesion force test after moisture absorption>

In order to measure a post-moisture-absorption adhesion force, a test piece was produced in a similar manner as the test for measuring the pre-moisture-absorption adhesion force. After being left in an atmosphere of 85°C/85%RH for 168 hours, this test piece was subjected to IR reflow at 260°C three times, and the versatile-type bond tester (DAGE SERIES 4000 by Nordson DAGE) was then used to measure a post-moisture-absorption adhesion force thereof at 25°C at a rate of 0.2 mm/sec.

<Adhesion force test after heat treatment>

In order to measure a post-heat-treatment adhesion force, a test piece was produced in a similar manner as the test for measuring the pre-moisture-absorption adhesion force. After leaving such test piece in an atmosphere of 180°C for 500 hours, the versatile-type bond tester (DAGE SERIES 4000 by Nordson DAGE) was then used to measure an adhesion force thereof at 25°C at a rate of 0.2 mm/sec.

These measurement results are shown in Tables 2 and 3. Further, detailed curing conditions A to C are as follows.

Curing condition A: 110°C for 30 min + 180°C for 2 hours
Curing condition B: 110°C for 30 min + 130°C for 2 hours
Curing condition C: 150°C for 1 hour + 200°C for 1 hour + 250°C for 4 hours

Here, as for the result of the comparative example 1, the example is one in which adhesion forces were measured without using a primer (varnish of composition). Thus, the fields of curing condition and curing atmosphere are empty.

[Table 1]

| Formulation table of composition (part by mass) | | | Formulation example | | | | | | | | | | | |
|---|---|---|---|---|---|---|---|---|---|---|---|---|---|---|
| | | | 1 | 2 | 3 | 4 | 5 | 6 | 7 | 8 | 9 | 10 | 11 | 12 |
| (A) | A-1 | A-1 | 1000 | 100.0 | | 100.0 | 100.0 | 1000 | 100.0 | | | | | |
| | A-2 | A-2 | | | 100.0 | | | | | | | | | |
| | BMI-5000 | A-3 | | | | | | | | 100.0 | 100.0 | 1000 | | |
| | BMI-1000 | A-4 | | | | | | | | | | | 1000 | 1000 |
| (B) | Perkadox BC-FF | B-1 | 2.0 | 2.0 | 2.0 | | 2.0 | 2.0 | 2.0 | 2.0 | 2.0 | 2.0 | 2.0 | 20 |
| | Kayalene 6-70 | B-2 | | | | 2.0 | | | | | | | | |
| (C) | 2E4MZ-A | C-1 | 1.0 | 2.5 | 1.0 | 10 | | | | | 10 | | | 1.0 |
| | 2E4MZ | C-2 | | | | | | 1.0 | | | | | | |
| | VD-5 | C-3 | | | | | | | 1.0 | | | 1.0 | | |

[Table 2]

| | | | Working example | | | | | |
|---|---|---|---|---|---|---|---|---|
| | | | 1 | 2 | 3 | 4 | 5 | 6 |
| Evaluation results | Composition used | | Formulation example 1 | Formulation example 2 | Formulation example 3 | Formulation example4 | Formulation example 4 | Formulation example 1 |
| | Curing condition | | A | A | A | B | B | A |
| | Curing atmosphere | | Nitrogen | Nitrogen | Nitrogen | Nitrogen | Air | Air |
| | Initial adhesion force | MPa | 35 | 35 | 32 | 30 | 30 | 13 |
| | Adhesion force after moisture absorption | MPa | 16 | 16 | 14 | 15 | 15 | 8 |
| | Adhesion force after heat treatment | MPa | 35 | 35 | 31 | 32 | 30 | 14 |

[Table 3]

| | | | Comparative example | | | | | | | | | | | | | |
|---|---|---|---|---|---|---|---|---|---|---|---|---|---|---|---|---|
| | | | 1 | 2 | 3 | 4 | 5 | 6 | 7 | 8 | 9 | 10 | 11 | 12 | 13 | 14 |
| Evaluation results | Composition used | | None | Formu-lation example 5 | Formu-lation example 5 | Formu-lation example 6 | Formu-lation example 7 | Formu-lation example 7 | Formu-lation example 8 | Formu-lation example 9 | Formu-lation example 9 | Formu-lation example 10 | Formu-lation example 11 | Formu-lation example 12 | KJR-655 | KJR-655 |
| | Curing condition | | - | A | A | A | A | A | A | A | A | A | A | A | C | C |
| | Curing atmosphere | | - | Air | Nitrogen | Nitrogen | Nitrogen | Oxygen | Nitrogen | Air | Nitrogen | Nitrogen | Nitrogen | Nitrogen | Nitrogen | Oxygen |
| | Initial adhesion force | MPa | 5 | 2 | 10 | 10 | 32 | 13 | 21 | 2 | 28 | 26 | <1 | 4 | 29 | 3 |
| | Adhesion force after moisture absorption | MPa | 1 | <1 | 5 | 5 | 4 | 3 | 11 | <1 | 11 | 7 | <1 | <1 | <1 | <1 |
| | Adhesion force after heat treatment | MPa | 3 | <1 | 8 | 8 | 26 | 10 | 10 | <1 | 10 | 11 | <1 | <1 | 28 | <1 |

As is evident from these results, the composition of the present invention was superior in adhesiveness in that its initial, post-moisture-absorption, and post-heat-treatment adhesion forces to copper were all higher than those in the comparative examples irrespective of curing atmosphere.

Further, the composition of the present invention was also superior to the compositions of the comparative examples in varnish stability over time. Thus, the composition of the present invention is suitable for use as a primer, especially a primer for a copper substrate and a primer used between a semiconductor encapsulation material and a lead frame.

## Claims

**1.** A curable maleimide resin composition comprising:

(A) a maleimide compound that is represented by a formula (1) or (2), and has a number average molecular weight of 5,000 to 50,000;
(B) a reaction initiator; and
(C) a diaminotriazine ring-containing imidazole,
the formula (1) being

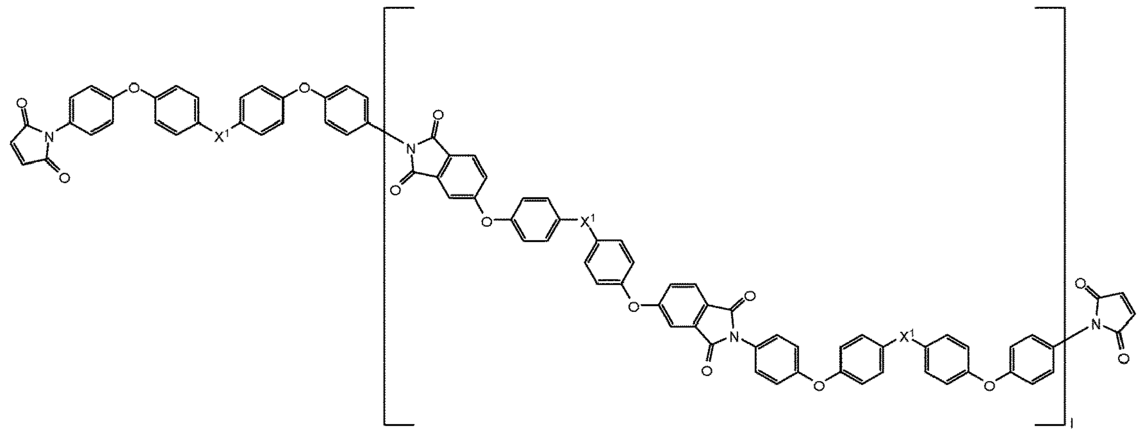

(1)

wherein in the formula (1), $X^1$ independently represents a divalent group selected from groups expressed by the following formulae, l is a number of 1 to 40

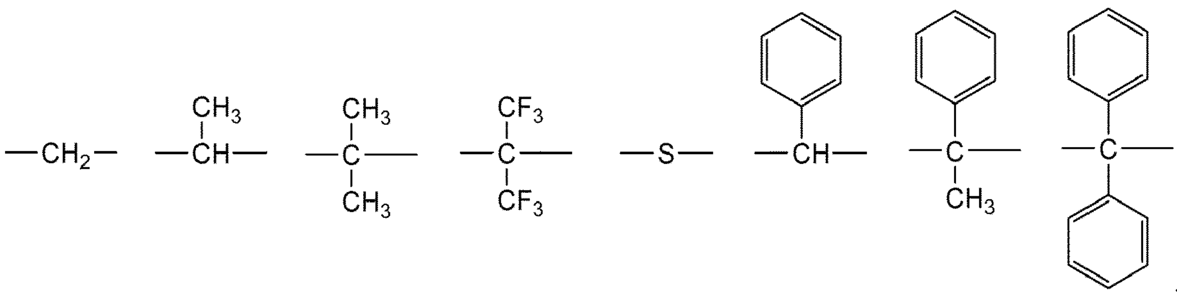

,

the formula (2) being

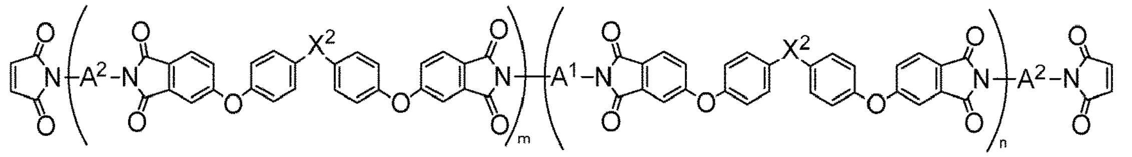

(2)

wherein in the formula (2), $X^2$ independently represents a divalent group selected from groups expressed by the following formulae, m is a number of 1 to 50, n is a number of 1 to 50, each of $A^1$ and $A^2$ independently represents a group expressed by a formula (3) or (4)

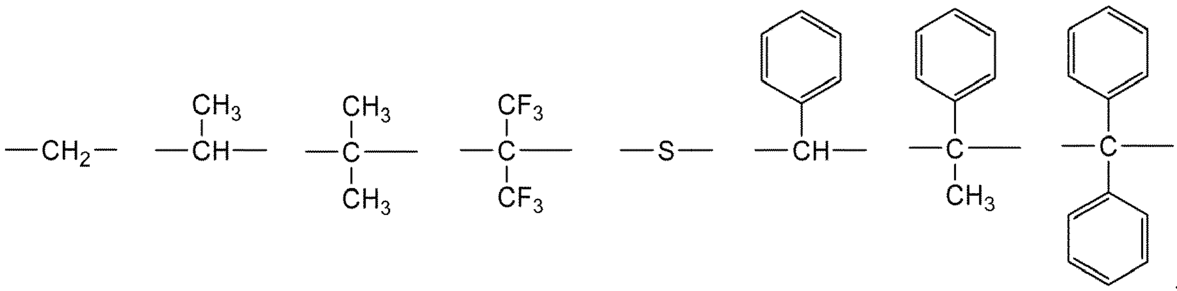

,

the formulae (3) and (4) being

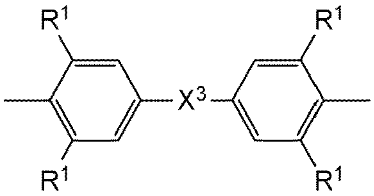

(3)

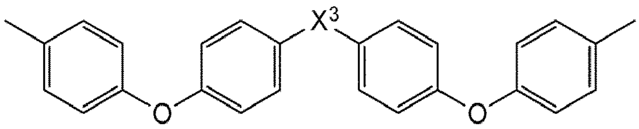

(4)

wherein in the formulae (3) and (4), $X^3$ represents a divalent group selected from groups expressed by the following formulae, $R^1$ in the formula (3) independently represents a hydrogen atom, a chlorine atom, or a substituted or unsubstituted aliphatic hydrocarbon group having 1 to 6 carbon atoms

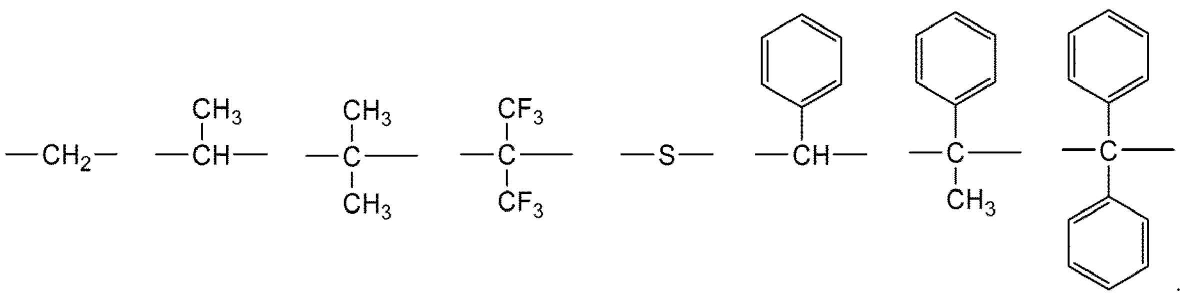

.

2. The curable maleimide resin composition according to claim 1, wherein the component (B) is contained in an amount of 0.05 to 10 parts by mass per 100 parts by mass of the component (A), and the component (C) is contained in an amount of 0.05 to 5 parts by mass per 100 parts by mass of the component (A).

3. The curable maleimide resin composition according to claim 1, further comprising (D) an organic solvent.

4. An adhesive comprised of the curable maleimide resin composition according to any one of claims 1 to 3.

5. A primer comprised of the curable maleimide resin composition according to any one of claims 1 to 3.

6. A chip coating agent comprised of the curable maleimide resin composition according to any one of claims 1 to 3.

**7.** A semiconductor device having a cured product of the curable maleimide resin composition according to any one of claims 1 to 3.

Europäisches Patentamt
European Patent Office
Office européen des brevets

# EUROPEAN SEARCH REPORT

Application Number
EP 24 15 0149

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 331 959 B1 (DESIGNER MOLECULES INC [US]) 5 October 2022 (2022-10-05)<br>* page 9, middle page chemical structure, claim 4 ; par. 0029-30, 0062, 0162, 0180, 0196, 0205, 0184 (ex. 2), 0200 (ex. 6), par. 0202 (ex. 7); claims 4, 8 *<br>----- | 1-7 | INV.<br>C08G73/12<br>C08K5/3445<br>C08L79/08<br>C09J4/00<br>H01L23/29<br>H01L23/00<br>C08F290/06<br>C08L71/12<br>C09D4/00<br>G03F7/00<br>G03F7/027<br>H05K1/03<br>H05K3/02 |
| A | US 2018/222152 A1 (UMEDA HIROAKI [JP] ET AL) 9 August 2018 (2018-08-09)<br>* page 3 - paragraph 0026-27; 0055-58; example 5; table 1; compound chem. form. 2 *<br>----- | 1-7 | |
| | | | TECHNICAL FIELDS SEARCHED (IPC) |
| | | | C08G<br>C09J<br>C08K<br>C08L<br>H01L<br>G03F<br>H05K<br>C08F<br>C09D |

The present search report has been drawn up for all claims

2

| Place of search | Date of completion of the search | Examiner |
|---|---|---|
| Munich | 21 May 2024 | Stefaniu, Cristina |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 24 15 0149

This annex lists the patent family members relating to the patent documents cited in the above-mentioned European search report. The members are as contained in the European Patent Office EDP file on
The European Patent Office is in no way liable for these particulars which are merely given for the purpose of information.

21-05-2024

| Patent document cited in search report | Publication date | Patent family member(s) | Publication date |
|---|---|---|---|
| EP 3331959 B1 | 05-10-2022 | CN 108291122 A | 17-07-2018 |
| | | EP 3331959 A1 | 13-06-2018 |
| | | JP 2018531317 A | 25-10-2018 |
| | | KR 20180029102 A | 19-03-2018 |
| | | US 2018237668 A1 | 23-08-2018 |
| | | WO 2017027482 A1 | 16-02-2017 |
| US 2018222152 A1 | 09-08-2018 | CN 107848261 A | 27-03-2018 |
| | | JP WO2017017923 A1 | 10-05-2018 |
| | | KR 20180032557 A | 30-03-2018 |
| | | TW 201710389 A | 16-03-2017 |
| | | US 2018222152 A1 | 09-08-2018 |
| | | WO 2017017923 A1 | 02-02-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2015048434 A
- JP 2015093971 A
- JP 2019176085 A
- JP 2022148684 A
- JP 2007008977 A
- JP 2010070645 A
- JP 2021025031 A
- WO 2020111065 A
- JP 2021017485 A